# EUROPÄISCHE PATENTSCHRIFT

(11) **EP 0 809 847 B1**
(45) Veröffentlichungstag und Bekanntmachung des Hinweises auf die Patenterteilung: **22.07.1998**
(21) Anmeldenummer: 96901232.7
(22) Anmeldetag: 05.02.1996
(51) Int. Cl.: G11C 11/56

(54) **MEHRWERTIGE FESTWERTSPEICHERZELLE MIT VERBESSERTEM STÖRABSTAND**
MULTI-VALUED READ-ONLY STORAGE LOCATION WITH IMPROVED SIGNAL-TO-NOISE RATIO
EMPLACEMENT MULTIFORME DE MEMOIRE MORTE A RAPPORT SIGNAL/PARASITES AMELIORE

(30) Priorität: 16.02.1995 DE 19505293
(43) Veröffentlichungstag der Anmeldung: 03.12.1997
(73) Patentinhaber: SIEMENS AKTIENGESELLSCHAFT, 80333 München (DE)
(72) Erfinder: SCHMITT-LANDSIEDEL, Doris, D-85521 Ottobrunn (DE); THEWES, Roland, D-82178 Puchheim (DE); BOLLU, Michael, D-81735 München (DE); BASSE, Paul-Werner, D-82515 Wolfratshausen (DE)
(86) Internationale Anmeldenummer: DE9600168
(87) Internationale Veröffentlichungsnummer: WO9625741

(56) Entgegenhaltungen:
- EP-A- 0 590 319
- EP-A- 0 643 489
- DE-A- 3 842 511
- GB-A- 2 157 489
- US-A- 5 296 726
- IBM TECHNICAL DISCLOSURE BULLETIN, Bd. 28, Nr. 7, Dezember 1985, NEW YORK US, Seiten 3048-3049, XP002004986 "read only memory"

## Beschreibung

Übliche Speicherzellen können jeweils 1 Bit Information speichern. Die beiden Zustände der Zelle können z.B. eine hohe oder niedrige Einsatzspannung des Transistors in einer 1-Transistorspeicherzelle sein. Bei dem Auslesevorgang werden die Bitleitungen in vielen bekannten Anordnungen zunächst auf eine definierte Spannung vorgeladen. Bei Ansteuerung der Zelle über die Wortleitung wird die an die Zelle angeschlossene Bitleitung je nach Zustand der Zelle mehr oder weniger umgeladen. So kann die Information der Zelle über einen hohen bzw. niedrigen Pegel der Bitleitung ausgelesen werden. Um eine hohe Störsicherheit zu erzielen, müssen die beiden Pegel einen möglichst hohen Spannungsunterschied aufweisen, z.B. positive Versorgungsspannung und 0 Volt.

Zur Erhöhung der Informationsdichte, wurden, insbesondere bei Festwertspeichern, gelegentlich auch mehrwertige Speicherzellen eingesetzt. Dabei handelt es sich um Speicherzellen, die jeweils ein Speichervermögen von mehr als 1 Bit aufweisen.

Aus der internationalen Patentanmeldung mit der Veröffentlichungsnummer WO 82/ 02977 ist ein maskenprogrammierbarer Festwertspeicher (ROM) bekannt, in dessen Speicherzellen mehr als nur zwei logische Zustände speicherbar sind. Um gleich große Zellen mit jeweils minimaler Größe zu erhalten, werden hierbei die logischen Zustände in den Zellen dadurch einprogrammiert, daß jeweils die Schwellenspannung (Einsatzspannung) des in der jeweiligen Zelle befindlichen Transistors getrennt eingestellt wird.

Hierbei müssen mehrere, z.B. vier, unterschiedliche Spannungs- oder Stromwerte zuverlässig unterschieden werden. Dies bedeutet einen höheren Schaltungsaufwand, z.B. für stabilisierte Referenzspannungen, und vor allem eine reduzierte Störsicherheit. Dies kann auch zu verringerter Ausbeute fuhren. Mehrwertige Speicherzellen haben vermutlich daher bis heute keine praktische Bedeutung erlangt. In modernen Speichern mit reduzierter Versorgungsspannung, z. B. mit 3,3V, sind die genannten Nachteile noch weniger akzeptabel.

Aus der Druckschrift GB-A-2 157 489 ist eine mehrwertige Festwertspeicherzelle bekannt, die zum Speichern eines ersten oder zweiten Zustandes symmetrisch und zum Speichern eines dritten oder vierten Zustandes unsymmetrisch aufgebaut ist.

Die der Erfindung zugrundeliegende Aufgabe liegt nun darin, eine mehrwertige Speicherzelle anzugeben, bei der ein möglichst geringer Schaltungsaufwand erforderlich ist und bei der der Störabstand gegenüber bekannten mehrwertigen Speicherzellen wesentlich verbessert ist. Diese Aufgabe wird erfindungsgemäß durch die im Patentanspruch 1 und 3 angegebenen Merkmale gelöst.

Der Patentanspruch 2 betrifft eine bevorzugte Ausgestaltung der Erfindung.

Die Erfindung wird nachfolgend anhand der Zeichnungen näher erläutert. Dabei zeigt
- Figur 1: Darstellungen einer Speicherzelle in den vier möglichen Zuständen,
- Figur 2A bis 2D: unterschiedliche Ausbildungen von MOS-Transistoren einer Speicherzelle zur Realisierung vier unterschiedlicher Speicherzustände,
- Figur 3: eine andere Ausführungsvariante zu Figur 2D,
- Figur 4: Schaltbild einer ersten erfindungsgemäßen Speicherzelle,
- Figur 5: ein Schnittdarstellung zur Erläuterung der Herstellung der Speicherzelle von Figur 4 und
- Figur 6: ein Schaltbild einer zweiten weiteren erfindungsgemäßen Speicherzelle.

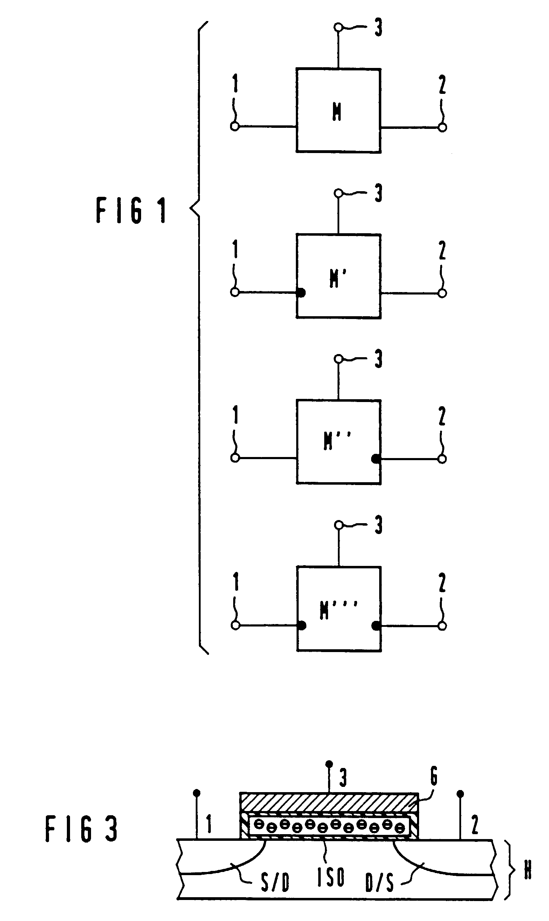

In Figur 1 sind in vier unterschiedlichen Zuständen M, M', M" und M"' programmierte erfindungsgemäße Speicherzellen mit ihren jeweiligen Zellenanschlüssen 1,2 und 3 dargestellt. Die Speicherzelle mit dem Zustand M weist dabei keine Markierung, die Speicherzelle mit dem Zustand M' am Zellenanschluß 1 eine Markierung in Form eines Punktes, die Speicherzelle mit dem Zustand M" am Zellenanschluß 2 eine Markierung in Form eines Punktes und die Speicherzelle mit dem Zustand M"' sowohl am Zellenanschluß 1 und 2 eine Markierung in Form eines Punktes auf. Die Speicherzellen mit den gespeicherten Zuständen M und M"' sind also bezüglich der Zellenanschlüsse 1 und 2 symmetrisch und die Speicherzellen mit den gespeicherten Zuständen M' und M" sind also bezüglich der Zellenanschlüsse 1 und 2 unsymmetrisch.

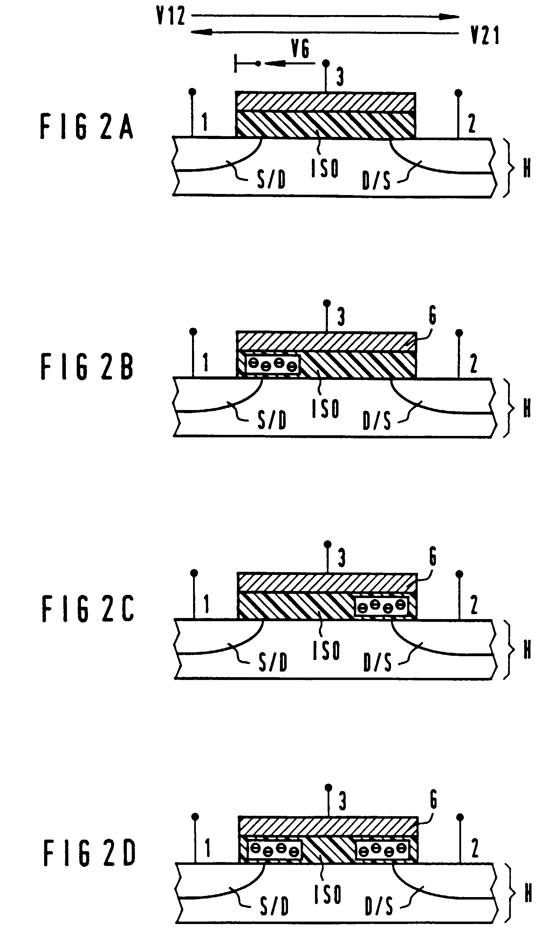

Die Figuren 2A bis 2D zeigen beispielhaft die Speicherung von 4 Zuständen in einem n-Kanal-Transistor, der sich beispielsweise in einer einmal programmierbaren Speicherzelle (OTP-Speicherzelle) befindet.

Figur 2A zeigt dabei den unprogrammierten symmetrischen MOS-Transistor. Im MOS-Transistor von Figur 2B wurden innerhalb eines Bereiches im Gateoxid nahe dem Zellenanschluß 1 negative Ladungen eingebracht. Damit ist eine höhere Gatespannung VG nötig, um unterhalb dieser Region einen Inversionskanal zu erzeugen, als unter dem Gateoxid nahe Zellenanschluß 2. Vereinfacht ausgedrückt bedeutet dies, daß die Einsatzspannung VT nahe Zellenanschluß 1 lokal erhöht ist. Bei Betrieb eines MOS-Transistors im Sättigungsbereich (Drain-Source-Spannung VDS > VG-VT) ist für den Einsatz der Leitfähigkeit näherungsweise nur die Einsatzspannung nahe des Source-Anschlusses bestimmend. Der Source-Anschluß ist definitionsgemäß derjenige der beiden Zellenanschlüsse 1 oder 2, der die niedrigere Spannung aufweist. Bei Ansteuerung von Zellenanschluß 1 als Source ergibt sich damit eine hohe Einsatzspannung und bei Ansteuerung von Zellenanschluß 2 als Source ergibt sich folglich eine niedrige Einsatzspannung. In Figur 2C sind die Zellenanschlüsse 1 und 2 gegenüber der Anordnung von Figur 2B praktisch nur vertauscht und die Verhältnisse sind entsprechend umgekehrt. Figur 2D zeigt hingegen den Fall einer beidseitig erhöhten Einsatzspannung.

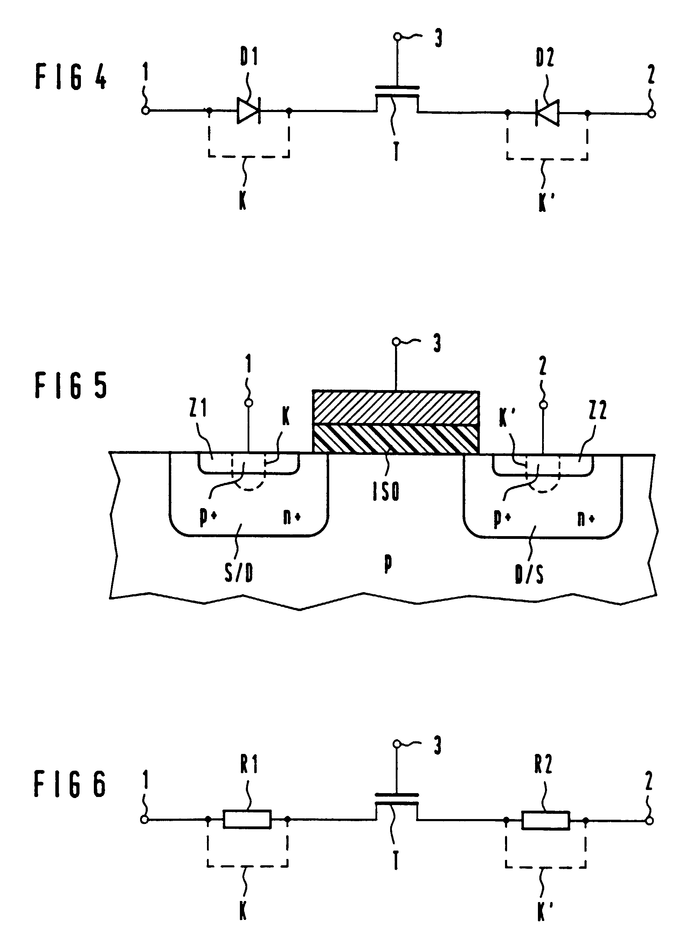

Figur 3 zeigt den Fall einer im ganzen Kanal erhöhten Einsatzspannung. Bezüglich des elektrischen Verhaltens sind die Transistoren von Figur 2D und Figur 3 gleichwertig, es können jedoch unterschiedliche Programmiermethoden verwendet werden, was im folgenden jedoch noch näher erläutert wird.

In der nachfolgen Tabelle ist der Reihe nach für die in den Figuren 2A bis 2D bzw. Figur 3 gezeigten Transistoren die Einsatzspannung (Schwellenspannung ) VT in Abhängigkeit der Polarität der Spannung VDS an den Zellenanschlüssen 1 und 2 sowie die zugehörige Zelleninformation als 2-Bit-Zahl angegeben. Beachtenswert ist hierbei, daß das auszulesende Signal den selben hohen Störabstand wie eine herkömmliche 1-Bit-Speicherzelle aufweist.

| VT mit VDS=V21>0 | VT mit VDS=V12>0 | Zelleninformation | |
|---|---|---|---|
| niedrig | niedrig | 0 0 | M |
| niedrig | erhöht | 0 1 | M' |
| erhöht | niedrig | 1 0 | M" |
| erhöht | erhöht | 1 1 | M"' |

Die Unterscheidung zwischen dem Zustand M" und M"' kann zum Beispiel dadurch vorgenommen werden, daß zuerst ein fester Pegel an den ersten Zellenanschluß 1 gelegt wird, die Bitleitung am Zellenanschluß 2 auf einen Vorladepegel vorgeladen wird, wobei sich dieser von dem festen Pegel am Zellenanschluß 1 unterscheidet, und anschließend die Änderung des Bitleitungspotentials nach Aktivierung der Speicherzelle bewertet wird. Danach wird der feste Pegel an den Zellenanschluß 2 gelegt, die Bitleitung am Zellenanschluß 1 vorgeladen und wieder die Potentialänderung der Bitleitung bewertet.

Die Bewertung kann auch dadurch erfolgen, daß zuerst ein erster fester Pegel an den Zellenanschluß 1 gelegt wird und der Pegel der Bitleitung am Zellenanschluß 2 bewertet wird und danach ein zweiter fester Pegel an den Zellenanschluß 1 gelegt wird und wieder der Pegel der Bitleitung am Zellenanschluß 2 bewertet wird.

Die erfindungsgemäße Speicherzelle eignet sich beispielsweise besonders für einmal programmierbare Speicher (OTP). Die Programmierung kann hierbei durch lokale Injektion von Elektronen in eine Oxid-Nitrid-Oxid-Schicht (ONO), die zumindest einen Bestandteil der Isolationsschicht ISO des MOS-Feldeffekttransistors darstellt, oder aber in eine übliche Oxidschicht erfolgen. Bei Injektion von "heißen" Ladungen bei hoher VDS werden hierbei diese Ladungen in einen kleinen Bereich in der Nähe des Drain-Gebietes injiziert. Die Vorteile sogenannter ONO-Schichten gegenüber üblichen Oxidschichten liegen darin, daß sie eine hohe Einfangwahrscheinlichkeit für Elektronen haben und daß praktisch keine laterale Bewegung dieser Ladungen erfolgt. Der Zustand nach Figur 3 kann durch eine homogene Injektion bewirkt werden.

Eine weitere Ausführungsform der Erfindung besteht darin, daß Kanalbereich in der Nähe eines Anschlusses anders dotiert wird als der übrige Kanal des MOS-Feldeffekttransistors. Dies kann beispielsweise über eine Implantationsmaske erfolgen, deren Öffnung nur einen Teil des Kanalbereichs überdeckt. Möglicherweise kann auch eine zusätzliche Dotierung vor der Source/Drain-Implantation bei z.B. abgedecktem Source-Bereich an Drain implantiert und von der Drain-Seite des Transistors her in den Kanal eindiffundiert werden. Die dafür benötigte Maske ist selbstjustierend und daher weniger kritisch. Ferner ist denkbar, die Source-Drain-Implantationen wahlweise mit flachen und mit spitzen Winkeln vorzunehmen. Die Implantation mit spitzen Winkeln, von beispielsweise 0 bis ca. 7 Grad, ist von Standardtechnologien bekannt. Erfahrungen mit flachen Winkeln, von beispielsweise 30 bis 60 Grad, gibt es aus der Entwicklung der LATID-Transistoren (Large-Angle-Tilted-Implanted-Drain). Die Maske für die Implantation mit flachem Winkel ist relativ unkritisch, da sie die betreffenden Source-Drain-Gebiete nur im Übergangsbereich zum Gateoxid überlappen muß und den Kanalbereich beliebig überlappen darf.

Alternativ zur Erhöhung der Einsatzspannung kann die Einsatzspannung, beispielsweise durch Einbringen von positiven Ladungen, auch reduziert werden.

Ferner können entsprechende Speicherelemente natürlich nicht nur mit n-Kanaltransistoren, sondern auch mit p-Kanaltransistoren realisiert werden.

Zur Erzeugung der Asymmetrie des Transistors sind nicht nur die Beeinflussung der Einsatzspannung, sondern beispielsweise auch die Veränderung der Oxiddicke oder unterschiedliche Transistorweiten nahe des Source- bzw. Drain-Anschlusses denkbar.

Ferner kann beim Auslesen der Speicherzelle eine Unterscheidung von drei unterschiedlichen Transistorzustände dadurch erfolgen, daß der Transistor entweder im linearen Bereich, also mit einer Drain-Source-Spannung VDS, die kleiner ist als die um die Schwellenspannung VT verminderte Gatespannung (VDS<VG-VT), oder im Sättigungsbereich betrieben wird. Die Anschlüsse werden in diesem Fall nicht umgepolt, sondern es wird nur die Höhe der Spannungsdifferenz von Zellenanschluß 1 und Zellenanschluß 2 geändert. Die Schwellenspannungen, die sich in den unterschiedlichen Arbeitspunkten ergeben, sind in der nachfolgenden Tabelle dargestellt.

| Fig. | VT mit V21>V31 | VT mit V21≈V31 | Zelleninf. | |
|---|---|---|---|---|
| 2A | niedrig | niedrig | 0 | M |
| 2B | hoch | niedrig | 1 | M' |
| 2D, 3 | hoch | hoch | 2 | M"' |

Neben der Erzeugung einer Symmetrie bzw. Asymmetrie innerhalb des MOS-Transistors T wird die Symmetrie bzw. Asymmetrie in einer weiteren Ausführungsform durch zusätzlich vorhandene Bauelemente, wie Dioden oder Widerstände bewirkt.

In Figur 4 ist ein MOS-Feldeffekttransistor dargestellt, dessen Source/Drain-Gebiet über eine Diode D1 mit dem Zellenanschluß 1, dessen Drain/Source-Gebiet über eine Diode D2 mit dem Zellenanschluß 2 und dessen Gateanschluß mit dem Zellenanschluß 3 verbunden sind. Je nach Programmierung, ist dabei die Diode D1 durch eine elektrisch leitende Verbindung K und die Diode D2 durch eine elektrisch leitende Verbindung K' überbrückbar. Wie hiermit vier unterschiedliche Zustände in einer entsprechenden Speicherzelle speicherbar sind, ist aus der nachfolgenden Tabelle entnehmbar.

| Diode an Zellenanschluß | V(2)-V(1) | Zellzustand | Zellinform. | |
|---|---|---|---|---|
| - | >0 | leitend | 0 0 | M |
| | <0 | leitend | | |
| 1 | >0 | sperrend | 0 1 | M' |
| | <0 | leitend | | |
| 2 | >0 | leitend | 1 0 | M" |
| | <0 | sperrend | | |
| 1 und 2 | >0 | sperrend | 1 1 | M"' |
| | <0 | sperrend | | |

In Figur 5 ist ein Schnittbild einer vorteilhaften Ausführungsform des der Speicherzelle von Figur 4 gezeigt, wobei in das hier beispielsweise n⁺-dotierte Source/Drain-Gebiet S/D zur Bildung der Diode D1 ein p⁺-Gebiet und in das hier beispielsweise n⁺-dotierte Drain/Source-Gebiet D/S zur Bildung der Diode D2 ebenfalls ein p⁺-Gebiet eingefügt ist. Zur Programmierung können in einem maskenprogrammierbaren Festwertspeicher (ROM) die Dioden durch Kontaktlöcher , die durch das p⁺-Gebiet bis zum n⁺-dotierten Source/Drain-Gebiet oder Drain/Source-Gebiet durchgeätzt sind und Kontaktierungen K und K' enthalten, überbrückt werden. Die Programmierung kann daher mittels einer zusätzlichen Kontaktlochmaske erfolgen.

Für eine elektrische Programmierung müssen die Dioden einzeln überbrückt werden können. Dies kann beispielsweise durch Anlegen einer hohen Spannung erfolgen, die z. B. durch Durchbrennen einer Oxidtrennschicht eine dauerhafte leitende Verbindung erzeugt.

Alternativ können auch ursprünglich vorhandene leitende Verbindungen durch Aufschmelzen einzeln unterbrochen werden.

Figur 6 unterscheidet sich von Figur 4 nur dadurch, daß anstelle der Dioden D1 und D2 Widerstände R1 und R2 vorgesehen sind. Hierbei kann dadurch eine Asymmetrie erzeugt werden, daß ein Widerstand in der Source-Zuleitung zu einer stärkeren Stromabnahme führt, als ein Widerstand in der Drain-Zuleitung.

Der Widerstand der Zellenanschlußgebiete kann durch Dichte der Dotierstoffe und Tiefe des dotierten Gebiets verändert werden. Der Kontaktlochwiderstand kann ebenfalls über die Herstellung, beispielsweise über die Ausführung der Barriere, beeinflußt werden. Die Programmierung kann ebenso, wie bei der Ausführungsform von Figur 4 beschrieben, über eine zusätzliche Maske oder elektrisch erfolgen.

## Patentansprüche

1. Mehrwertige Festwertspeicherzelle, die zum Speichern eines ersten oder zweiten Zustandes (M, M"') symmetrisch und zum Speichern mindestens eines dritten Zustandes (M',M") unsymmetrisch aufgebaut ist, wobei die Festwertspeicherzelle einen MOS-Feldeffekt-Transistor (T) mit einem im Halbleiterkörper (H) befindlichen Source/Drain-Gebiet (S/D) und mit einem im Halbleiterkörper befindlichen Drain/Source-Gebiet (D/S) umfaßt,
bei der zur Speicherung des ersten Zustandes (M) ein erster Zellenanschluß (1) direkt mit dem Source/Drain-Gebiet (S/D) des MOS-Feldeffekttransistors und ein zweiter Zellenanschluß (2) direkt dem Drain/Source-Gebiet (D/S) des MOS-Feldeffekttransistors verbunden sind,
bei der zur Speicherung des zweiten Zustandes (M"') der erste Zellenanschluß (1) über ein Bauelement (D1, R1) mit dem Source/Drain-Gebiet (S/D) des MOS-Feldeffekttransistors und der zweite Zellenanschluß (2) über ein weiteres Bauelement (D2,R2) mit dem Drain/Source-Gebiet (D/S) des MOS-Feldeffekttransistors verbunden sind,
bei der zur Speicherung des dritten Zustandes (M') der erste Zellenanschluß (1) über das Bauelement (D1,R1) mit dem Source/Drain-Gebiet (S/D) des MOS-Feldeffekttransistors und der zweite Zellenanschluß (2) direkt mit dem Drain/Source-Gebiet (D/S) des MOS-Feldeffekttransistors verbunden sind,
bei der gegebenenfalls zur Speicherung eines vierten Zustandes (M'') der erste Zellenanschluß (1) direkt mit dem Source/Drain-Gebiet (S/D) des MOS-Feldeffekttransistors und der zweite Zellenanschluß (2) über ein weiteres Bauelement (D2,R2) mit dem Drain/Source-Gebiet (D/S) des MOS-Feldeffekttransistors verbunden sind,
bei der ein dritter Zellenanschluß (3) mit einer Gateelektrode (G) des MOS-Feldeffekttransistors verbunden ist, wobei die Gateelektrode vom Halbleiterkörper durch eine Isolationsschicht (ISO) elektrisch isoliert ist, und
bei der das Bauelement eine erste Diode (D1) und das weitere Bauelement eine zweite Diode (D2) sind.

2. Mehrwertige Festwertspeicherzelle nach Anspruch 1,
bei der der erste Zellezanschluß (1), zur Bildung der ersten Diode (D1), über ein erstes Zusatzgebiet (Z1) mit dem Source/Drain-Gebiet (S/D) des MOS-Feldeffekttransistors und der zweite Zellenanschluß (2), zur Bildung der zweiten Diode (D2), über ein zweites Zusatzgebiet (Z2) mit dem Drain/Source-Gebiet (D/S) des MOS-Feldeffekttransistors verbunden sind,
bei der zur Speicherung des ersten Zustandes (M) sowohl das erste als auch das zweite Zusatzgebiet (Z1,Z2) durch tief ausgebildete, bis mindestens an das Source/Drain-Gebiet (S/D) und Drain/Source-Gebiet (D/S) reichende, metallische Kontaktierungen (K, K') des ersten und zweiten Anschlusses (1,2) überbrückt sind,
bei der zur Speicherung des zweiten Zustandes (M"') sowohl das erste als auch das zweite Zusatzgebiet (Z1,Z2) nur durch flach ausgebildete, lediglich bis mindestens an die beiden Zusatzgebiete reichende, metallische Kontaktierungen des ersten und zweiten Anschlusses (1,2) kontaktiert sind,
bei der zur Speicherung des dritten Zustandes (M') nur das erste Zusatzgebiet (Z1) durch eine tief ausgebildete, bis mindestens an das Source/Drain-Gebiet (S/D) reichende, metallische Kontaktierung des ersten Anschlusses (1) überbrückt ist und
bei der gegebenenfalls zur Speicherung des vierten Zustandes (M'') nur das zweite Zusatzgebiet (Z2) durch eine tief ausgebildete, bis mindestens an das Drain/Source-Gebiet (D/S) reichende, metallische Kontaktierung des ersten Anschlusses (1) überbrückt ist.

3. Mehrwertige Festwertspeicherzelle, die zum Speichern eines ersten oder zweiten Zustandes (M, M"') symmetrisch und zum Speichern mindestens eines dritten Zustandes (M',M") unsymmetrisch aufgebaut ist, wobei die Festwertspeicherzelle einen MOS-Feldeffekt-Transistor (T) mit einem im Halbleiterkörper (H) befindlichen Source/Drain-Gebiet (S/D) und mit einem im Halbleiterkörper befindlichen Drain/Source-Gebiet (D/S) umfaßt,
bei der zur Speicherung des ersten Zustandes (M) ein erster Zellenanschluß (1) direkt mit dem Source/Drain-Gebiet (S/D) des MOS-Feldeffekttransistors und ein zweiter Zellenanschluß (2) direkt mit dem Drain/Source-Gebiet (D/S) des MOS-Feldeffekttransistors verbunden sind,
bei der zur Speicherung des zweiten Zustandes (M"') der erste Zellenanschluß (1) über ein Bauelement (D1, R1) mit dem Source/Drain-Gebiet (S/D) des MOS-Feldeffekttransistors und der zweite Zellenanschluß (2) über ein weiteres Bauelement (D2,R2) mit dem Drain/Source-Gebiet (D/S) des MOS-Feldeffekttransistors verbunden sind,
bei der zur Speicherung des dritten Zustandes (M') der erste Zellenanschluß (1) über das Bauelement (D1,R1) mit dem Source/Drain-Gebiet (S/D) des MOS-Feldeffekttransistors und der zweite Zellenanschluß (2) direkt mit dem Drain/Source-Gebiet (D/S) des MOS-Feldeffekttransistors verbunden sind,
bei der gegebenenfalls zur Speicherung eines vierten Zustandes (M'') der erste Zellenanschluß (1) direkt mit dem Source/Drain-Gebiet (S/D) des MOS-Feldeffekttransistors und der zweite Zellenanschluß (2) über ein weiteres Bauelement (D2,R2) mit dem Drain/Source-Gebiet (D/S) des MOS-Feldeffekttransistors verbunden sind,
bei der ein dritter Zellenanschluß (3) mit einer Gateelektrode (G) des MOS-Feldeffekttransistors verbunden ist, wobei die Gateelektrode vom Halbleiterkcrper durch eine Isolationsschicht (ISO) elektrisch isoliert ist, und
bei der das Bauelement ein erster Widerstand (R1) und das weitere Bauelement ein zweiter Widerstand (R2) sind.

## Claims

1. Multi-value read-only memory cell, which is of symmetrical construction for the purpose of storing a first or second state (M, M"') and of asymmetrical construction for the purpose of storing at least a third state (M', M"'), the read-only memory cell comprising a MOS field-effect transistor (T) having a source/drain region (S/D) situated in the semiconductor body (H) and having a drain/source region (D/S) situated in the semiconductor body,
in which, in order to store the first state (M), a first cell connection (1) is connected directly to the source/drain region (S/D) of the MOS field-effect transistor and a second cell connection (2) is connected directly to the drain/source region (D/S) of the MOS field-effect transistor,
in which, in order to store the second state (M"'), the first cell connection (1) is connected via a component (D1, R1) to the source/drain region (S/D) of the MOS field-effect transistor and the second cell connection (2) is connected via a further component (D2, R2) to the drain/source region (D/S) of the MOS field-effect transistor,
in which, in order to store the third state (M'), the first cell connection (1) is connected via the component (D1, R1) to the source/drain region (S/D) of the MOS field-effect transistor and the second cell connection (2) is connected directly to the drain/source region (D/S) of the MOS field-effect transistor,
in which, if appropriate, in order to store a fourth state (M"), the first cell connection (1) is connected directly to the source/drain region (S/D) of the MOS field-effect transistor and the second cell connection (2) is connected via a further component (D2, R2) to the drain/source region (D/S) of the MOS field-effect transistor,
in which a third cell connection (3) is connected to a gate electrode (G) of the MOS field-effect transistor, the gate electrode being electrically insulated from the semiconductor body by means of an insulation layer (ISO), and
in which the component is a first diode (D1) and the further component is a second diode (D2).

2. Multi-value read-only memory cell according to Claim 1,
in which, in order to form the first diode (D1), the first cell connection (1) is connected via a first supplementary region (Z1) to the source/drain region (S/D) of the MOS field-effect transistor and, in order to form the second diode (D2), the second cell connection (2) is connected via a second supplementary region (Z2) to the drain/source region (D/S) of the MOS field-effect transistor,
in which, in order to store the first state (M), both the first and the second supplementary region (Z1, Z2) are bridged by metallic contact links (K, K') of the first and second connections (1, 2), which contact links are of deep design and extend at least as far as the source/drain region (S/D) and drain/source region (D/S), in which, in order to store the second state (M"'), both the first and the second supplementary region (Z1, Z2) are made contact with only by means of metallic contact links of the first and second connections (1, 2), which contact links are of shallow design and extend only at least as far as the two supplementary regions,
in which, in order to store the third state (M'), only the first supplementary region (Z1) is bridged by a metallic contact link of the first connection (1), which contact link is of deep design and extends at least as far as the source/drain region (S/D), and
in which, if appropriate, in order to store the fourth state (M"), only the second supplementary region (Z2) is bridged by a metallic contact link of the first connection (1), which contact link is of deep design and extends as least as far as the drain/source region (D/S).

3. Multi-value read-only memory cell, which is of symmetrical construction for the purpose of storing a first or second state (M, M"') and of asymmetrical construction for the purpose of storing at least a third state (M', M"), the read-only memory cell comprising a MOS field-effect transistor (T) having a source/drain region (S/D) situated in the semiconductor body (H) and having a drain/source region (D/S) situated in the semiconductor body,
in which, in order to store the first state (M), a first cell connection (1) is connected directly to the source/drain region (S/D) of the MOS field-effect transistor and a second cell connection (2) is connected directly to the drain/source region (D/S) of the MOS field-effect transistor,
in which, in order to store the second state (M"'), the first cell connection (1) is connected via a component (D1, R1) to the source/drain region (S/D) of the MOS field-effect transistor and the second cell connection (2) is connected via a further component (D2, R2) to the drain/source region (D/S) of the MOS field-effect transistor,
in which, in order to store the third state (M'), the first cell connection (1) is connected via the component (D1, R1) to the source/drain region (S/D) of the MOS field-effect transistor and the second cell connection (2) is connected directly to the drain/source region (D/S) of the MOS field-effect transistor,
in which, if appropriate, in order to store a fourth state (M"), the first cell connection (1) is connected directly to the source/drain region (S/D) of the MOS field-effect transistor and the second cell connection (2) is connected via a further component (D2, R2) to the drain/source region (D/S) of the MOS field-effect transistor,
in which a third cell connection (3) is connected to a gate electrode (G) of the MOS field-effect transistor, the gate electrode being electrically insulated from the semiconductor body by means of an insulation layer (ISO), and
in which the component is a first resistor (R1) and the further component is a second resistor (R2).

## Revendications

1. Cellule de mémoire morte à plusieurs états, qui est de construction symétrique pour stocker un premier ou un deuxième état (M, M"') et de construction asymétrique pour stocker au moins un troisième état (M', M"), la cellule de mémoire morte comprenant un transistor à effet de champ MOS (T) avec une région source/drain (S/D) située dans le corps à semi-conducteur (H) et avec une région drain/source (D/S) située dans le corps à semi-conducteur,
dans laquelle, pour stocker le premier état (M), une première borne de cellule (1) est reliée directement à la région source/drain (S/D) du transistor à effet de champ MOS et une deuxième borne de cellule (2) directement à la région drain/source (D/S) du transistor à effet de champ MOS ,
dans laquelle, pour stocker le deuxième état (M"'), la première borne de cellule (1) est reliée via un composant (D1, R1) à la région source/drain (S/D) du transistor à effet de champ MOS et la deuxième borne de cellule (2) via un autre composant (D2, R2) à la région drain/source (D/S) du transistor à effet de champ MOS,
dans laquelle, pour stocker le troisième état (M'), la première borne de cellule (1) est reliée via le composant (D1, R1) à la région source/drain (S/D) du transistor à effet de champ MOS et la deuxième borne de cellule (2) directement à la région drain/source (D/S) du transistor à effet de champ MOS,
dans laquelle, pour stocker le cas échéant un quatrième état (M"), la première borne de cellule (1) est reliée directement à la région source/drain (S/D) du transistor à effet de champ MOS et la deuxième borne de cellule (2) via un autre composant (D2, R2) à la région drain/source (D/S) du transistor à effet de champ MOS,
dans laquelle une troisième borne de cellule (3) est reliée à une électrode de grille (G) du transistor à effet de champ MOS, l'électrode de grille étant isolée électriquement du corps à semi-conducteur par une couche isolante (ISO), et
dans laquelle le composant est une première diode (D1) et l'autre composant une deuxième diode (D2).

2. Cellule de mémoire morte à plusieurs états selon la revendication 1,
dans laquelle la première borne de cellule (1), pour former la première diode (D1), est reliée via une première région auxiliaire (Z1) à la région source/drain (S/D) du transistor à effet de champ MOS et la deuxième borne de cellule (2), pour former la deuxième diode (D2), via une deuxième région auxiliaire (Z2) à la région drain/source (D/S) du transistor à effet de champ MOS,
dans laquelle, pour stocker le premier état (M), tant la première que la deuxième région auxiliaire (Z1, Z2) sont shuntées par des contacts métalliques (K, K') de la première et de la deuxième borne (1, 2), réalisés en profondeur et s'avançant au moins jusqu'à la région source/drain (S/D) et la région drain/source (D/S),
dans laquelle, pour stocker le deuxième état (M'''), tant la première que la deuxième région auxiliaire (Z1, Z2) sont mises en contact uniquement par des contacts métalliques de la première et de la deuxième borne (1, 2), réalisés à plat et ne s'avançant au moins que jusqu'aux deux régions auxiliaires,
dans laquelle, pour stocker le troisième état (M'), seule la première région auxiliaire (Z1) est shuntée par un contact métallique de la première borne (1), réalisé en profondeur et s'avançant au moins jusqu'à la région source/drain (S/D), et
dans laquelle, pour stocker le cas échéant le quatrième état (M''), seule la deuxième région auxiliaire (Z2) est shuntée par un contact métallique de la première borne (1), réalisé en profondeur et s'avançant au moins jusqu'à la région drain/source (D/S).

3. Cellule de mémoire morte à plusieurs états, qui est de construction symétrique pour stocker un premier ou un deuxième état (M, M"') et de construction asymétrique pour stocker au moins un troisième état (M', M"), la cellule de mémoire morte comprenant un transistor à effet de champ MOS (T) avec une région source/drain (S/D) située dans le corps à semi-conducteur (H) et avec une région drain/source (D/S) située dans le corps à semi-conducteur,
dans laquelle, pour stocker le premier état (M), une première borne de cellule (1) est reliée directement à la région source/drain (S/D) du transistor à effet de champ MOS et une deuxième borne de cellule (2) directement à la région drain/source (D/S) du transistor à effet de champ MOS ,
dans laquelle, pour stocker le deuxième état (M'''), la première borne de cellule (1) est reliée via un composant (D1, R1) à la région source/drain (S/D) du transistor à effet de champ MOS et la deuxième borne de cellule (2) via un autre composant (D2, R2) à la région drain/source (D/S) du transistor à effet de champ MOS,
dans laquelle, pour stocker le troisième état (M'), la première borne de cellule (1) est reliée via le composant (D1, R1) à la région source/drain (S/D) du transistor à effet de champ MOS et la deuxième borne de cellule (2) directement à la région drain/source (D/S) du transistor à effet de champ MOS,
dans laquelle, pour stocker le cas échéant un quatrième état (M"), la première borne de cellule (1) est reliée directement à la région source/drain (S/D) du transistor à effet de champ MOS et la deuxième borne de cellule (2) via un autre composant (D2, R2) à la région drain/source (D/S) du transistor à effet de champ MOS,
dans laquelle une troisième borne de cellule (3) est reliée à une électrode de grille (G) du transistor à effet de champ MOS, l'électrode de grille étant isolée électriquement du corps à semi-conducteur par une couche isolante (ISO), et
dans laquelle le composant est une première résistance (R1) et l'autre composant une deuxième résistance (R2).
